# EUROPEAN PATENT APPLICATION

(11) **EP 0 543 618 A2**
(43) Date of publication of application: **26.05.1993**
(21) Application number: 92310480.6
(22) Date of filing: 18.11.1992
(51) Int. Cl.: H03M 1/12, H03M 3/02

(54) **Analogue-to-digital converter**

(30) Priority: 20.11.1991 GB 9124591
(71) Applicant: GEC-MARCONI LIMITED, Stanmore, Middlesex HA7 4LY (GB)
(72) Inventor: Thurston, Andrew Mark, Chelmsford, Essex CM1 5QS (GB)
(74) Representative: Waters, Jeffrey

(57) **Abstract**

In a conventional sigma-delta analogue-to-digital converter an input such as an i.f. signal at i/p is converted to digital form by analogue-to-digital converter 9 at output o/p, and the quantising noise is shaped by means of a feedback loop which feeds a signal derived from the digital output to be combined in analogue form with the analogue input to form a difference signal for input to filter means 6, 7, the filtered difference signal being applied to the input of the analogue-to-digital converter 9. In the invention, to improve the signal-to-noise ratio, the analogue-to-digital converter 9 has more levels of quantisation than the digital-to-analogue converter 4 but the latter is clocked at a faster rate.

## Description

This invention relates to analogue-to-digital converters, particularly analogue-to-digital converters of the sigma-delta type.

Such converters comprise an input for analogue signals, quantising means for producing a digital output, oversampled relative to the signal bandwidth, a feedback loop for feeding a signal derived from the digital output to be combined in analogue form with the analogue input to form a difference signal for input to filter means, the filtered difference signal being applied to the input of the quantising means.

Such converters are known in baseband and band pass form, (GB-A-2232023), and have favourable signal-to-noise ratio properties on account of the quantisation noise shaping which takes place within the converter. Such converters are particularly suitable for i.f. radio signals.

The extent to which the quantising noise is shaped in the signal passband (and thus the signal-to-noise ratio of the converter) depends upon the order of the loop filter within the sigma-delta analogue-to-digital converter. Baseband and bandpass converters using single bit quantisation may employ second order loop filtering. The use of higher order loop filters imposes greater demands to ensure loop stability. One way of achieving higher order loop filters without loop stability being an insuperable problem is by arranging that the quantising means produces more than two levels of quantisation in operation. The reason why this has not been widely adopted is the difficulty in accurately converting into analogue form the signal in the feedback loop derived from the digital output. Any non-linearity in conversion in the feedback loop is not suppressed by the loop gain, only non-linearities in the forward path including the quantising means are. For this reason, sigma-delta converters usually employ two levels only of quantisation.

One proposal to utilise the advantages of more than two levels of quantisation for the digital output while retaining the linearity advantages of two level digital-to-analogue conversion in the feedback loop operates by converting a multi-bit digital signal in the feedback loop to a single bit digital signal ("A simple method to obtain significant improvement in the performance of oversampled analogue-to-digital converters", f.j. harris, A. Constantinides, W. McKnight, and E. Brooking, ISSPA-90, International Symposium on Signal Processing Applications, Gold Coast, Australia, 27-29th August 1990). The conversion to one bit introduces quantisation noise, which is not suppressed by the loop gain, but the noise spectrum is shaped to reduce it in the signal passband.

The invention provides an analogue-to-digital converter comprising an input for analogue signals, quantising means for producing a digital output with more than two levels of quantisation, a feedback loop for feeding a signal derived from the digital output to be combined in analogue form with the analogue input to form a difference signal for input to filter means, the filtered difference signal being applied to the input of the quantising means in use, wherein the feedback loop includes means for converting the signal derived from the digital output to a second digital signal with fewer levels of quantisation but a higher clocking rate than the digital output.

The higher clocking rate of the second digital signal enables the converter to be wholly or partially transparent to the quantisation noise associated with the conversion to fewer levels.

It is advantageous to convert the digital output to two levels for example by converting a parallel data stream to a serial data stream, and this may be accomplished by a look-up table.

The second digital signal will be at a higher clocking rate than the digital output.

Sigma-delta analogue-to-digital converters constructed in accordance with the invention will now be described by way of example with reference to the accompanying drawings, in which:
Figure 1 is a known form of second order sigma-delta analogue-to-digital converter;
Figure 2 is a graph showing the relation between the quantisation noise and frequency for the converter shown in Figure 1;
Figure 3 is vector diagram representing an incoming i.f. signal to be digitised;
Figures 3a to 3e are corresponding vector diagrams showing particular combinations of feedback pulses;
Figure 4 shows the general form of three types of sigma-delta analogue-to-digital converter constructed in accordance with the invention; and
Figure 5 shows a look-up table associated with one of the types.

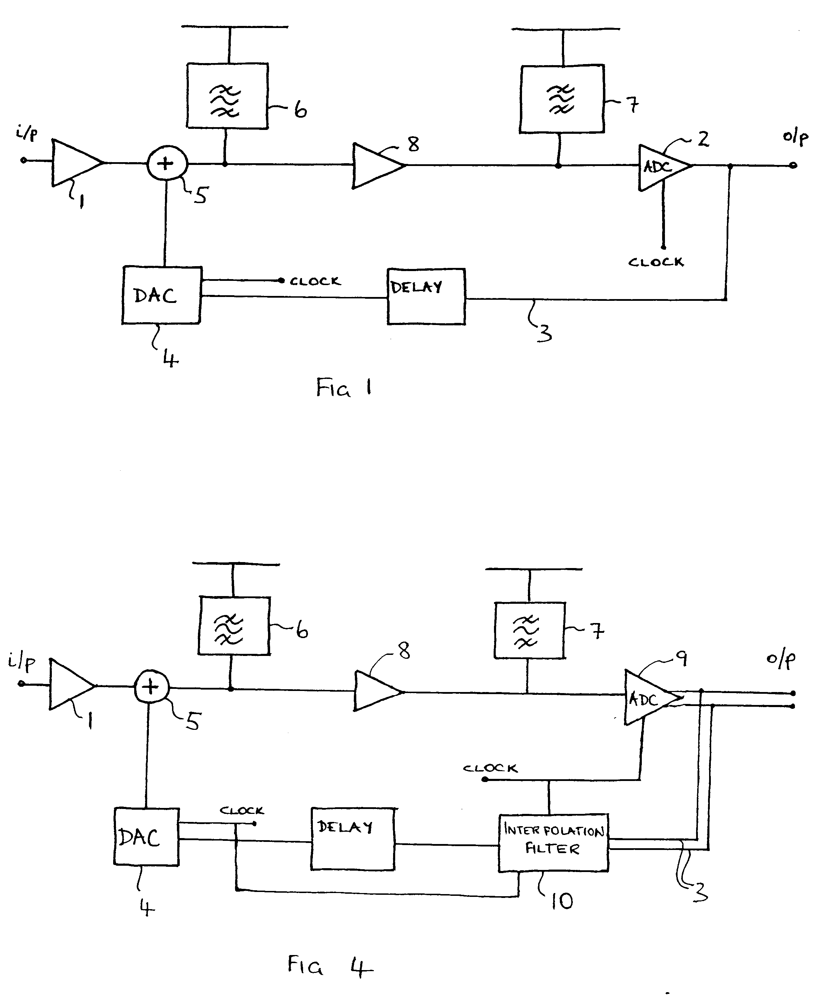

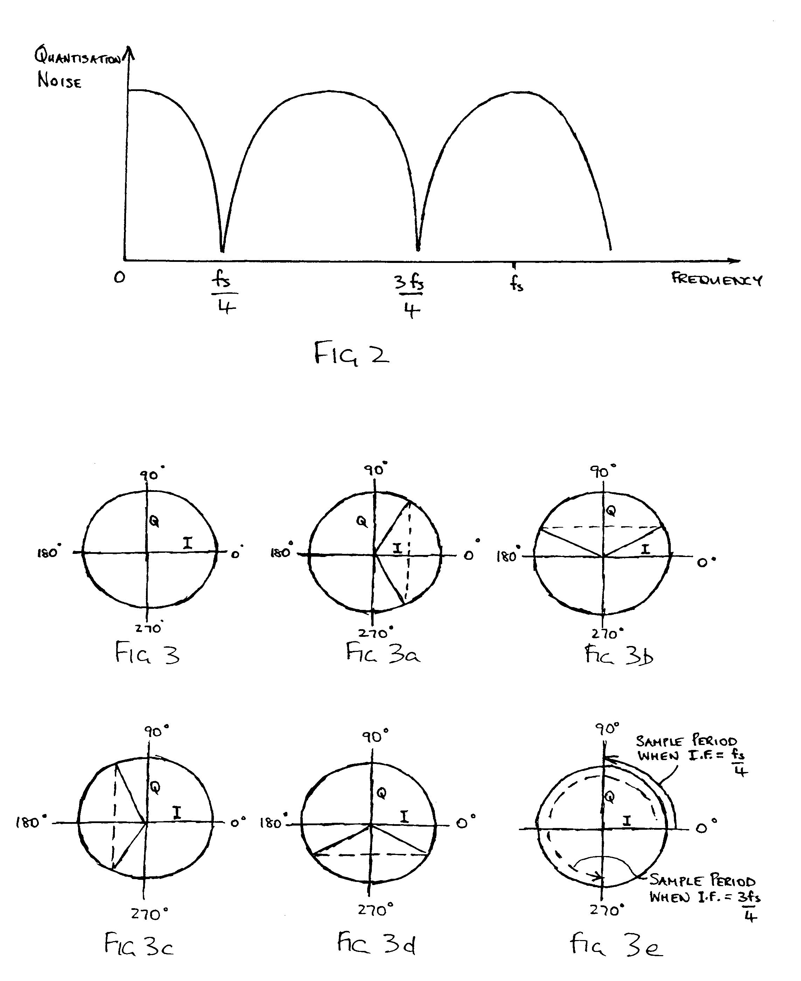

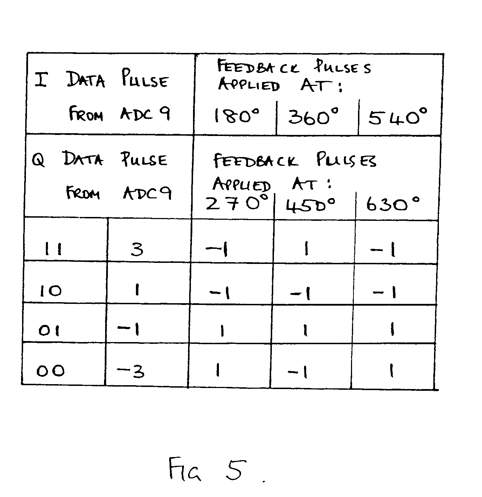

Referring to Figure 1, a known sigma-delta analogue-to-digital converter is suitable for i.f. radio signals having a defined bandwidth. The converter is a second order bandpass sigma-delta analogue-to-digital converter, and converts an analogue input fed to input i/p of a voltage to current amplifier 1 to a quantised and sampled digital output o/p from quantising means 2 in the form of an analogue-to-digital converter such as a clocked comparator. A feedback loop 3 provides a feedback signal which is converted to analogue form in digital-to-analogue converter 4. The latter is a high linearity switchable current source and its output is combined at adder 5 with the analogue input. The time delay around the feedback loop is half a cycle at i.f. so that the feedback is negative feedback and the signal fed to bandpass filters 6, 7 is a difference signal. The effect of the filters 6, 7 is to perform a bandpass integration function, the filtered difference signal being fed to the input of the analogue-to-digital converter 2. The first stage of the bandpass filter (a series connection of resistive means and an inductive capacitative parallel resonant circuit tuned to the i.f. frequency) develops a voltage which is converted to current in a voltage to current amplifier 8 which applies a current to the second stage of the filter, (also a series connection of resistive means and inductive capacitative parallel resonant circuit tuned to to the i.f. frequency), which presents a voltage to the analogue-to-digital converter 2. The effect of the integration of the difference signal (hence sigma-delta) is to shape the quantisation noise of the sigma-delta converter into the form shown in Figure 2, where it will be seen that there are nulls in the quantisation noise at one quarter, three quarters, five quarters etc of the frequency of sampling of the quantised output of the analogue-to-digital converter 2. The filter stages are tuned to one quarter of the sampling frequency, so that incoming i.f. signals of this frequency have minimum quantisation noise added to them. The quantisation noise out of bandwidth of the analogue signal is digitally filtered from the output o/p and the sampling rate reduced in a decimation filter (not shown). The delay around the feedback loop is arranged to be two sample periods corresponding to negative feedback given that the i.f. frequency is one quarter of the sampling frequency i.e. one wavelength of the analogue signal is four sample periods long. In the interests of linearity, the analogue-to-digital converter 2 and the digital-to-analogue converter 4 are both one bit but, if desired both could be multi-bit. One feedback pulse is applied in response to every data output pulse, and (Figure 3) this means that four feedback pulses are applied per cycle of the i.f. signal.

Such sigma-delta converters are known (e.g. GB-A-2232023), and are used to obtain favourable signal-to-noise ratio.

Referring to Figure 4, in which like parts to those in Figure 1 have been given like reference numerals, in accordance with the invention, in order to improve still further the signal-to-noise ratio, the analogue-to-digital converter 9 has three output levels instead of the two of analogue-to-digital converter 2 of Figure 1 and an interpolation filter 10 converts the three levels fed on a parallel data stream to the two levels of digital-to-analogue converter 4. Digital-to-analogue converter 4 is operated at a faster conversion (clocking) rate than the sampling (clocking) rate of the analogue-to-digital converter 9, producing pulse density modulation, and the feedback pulses are applied in step with the output data samples in such a way as to produce the effect of three linearly related levels.

This is achieved by applying feedback pulses from digital-to-analogue converter 4 every 30° of i.f. frequency instead of every 90° as hitherto i.e. digital-to-analogue converter 4 runs at three times the rate of analogue-to-digital converter 9 i.e. at twelve times the i.f. frequency. Thus, referring to Figure 3a, secondary positive pulses (assuming the binary states are positive and negative) centered on 60° and 300° serve to produce the same effect as a single positive primary pulse centered on zero, since the I components of the pulses sum to unity (2 x Cos 60° = 2 x ½ = 1) and the Q components cancel. Equally, negative pulses at 60° and 300° produce the same effect as one negative pulse centered at 0°.

By the same token, secondary pulses at 30° and 150° are equivalent to a primary pulse at 90°, (Figure 3b) secondary pulses at 120° and 240° are equivalent to a primary pulse at 180° (Figure 3c) and secondary pulses at 210° and 330° are equivalent to a primary pulse at 270° (Figure 3d).

Over a complete i.f. cycle, feedback equivalent to two positive pulses, two negative pulses or zero at 0, 90°, 180° and 270° can thus be applied. These three levels of feedback are applied in step with the respective three output levels at analogue-to-digital converter 9, and the interpolation filter contains an appropriate look-up table to instruct the digital-to-analogue converter 4 to operate at the appropriate time. The interpolation filter is clocked at the same rate as digital-to-analogue converter 4.

The individual feedback pulses have two levels (positive or negative) compared with the three levels of the output of the converter, but the converter is transparent to the quantisation noise introduced by the conversion. This is because the performance of the converter depends on the open loop impulse response of the analogue filter 6, 7, which is designed to give the same response at the sampling instants as the digital equivalent of the analogue filter would give. (One way of choosing component values is to choose them to produce a particular impulse response, itself determined to match, at the sampling instants, the response of a digital filter with a desired characteristic). Respective positive or negative primary pulses and appropriate pairs of secondary pulses will produce the same impulse response at the sampling instants of the analogue-to-digital converter 9 as would three-level feedback pulses of plus two units, zero, or minus two units. Hence, the converter is transparent to the quantisation noise introduced by the truncation and behaves as if such three-level pulses were applied.

Thus, by running the digital-to-analogue converter 4 at a faster rate than the analogue-to-digital converter 9, and using an interpolation look-up table to cause the digital-to-analogue converter 4 to generate primary feedback pulses and associated pairs of secondary feedback pulses, the multi-level quantiser arrangement described extends the dynamic range of the sigma-delta conversion technique while maintaining the linearity advantages of using a single bit digital-to-analogue converter. The dynamic range is extended because, since the quantiser is multi-level, it will accept larger signals at its input before the onset of overload. Also, since the quantiser is multi-level, it will have a better defined gain and higher linearity than if it were a single bit quantiser, so that the noise shaping properties and the linearity of the modulation process will be improved.

An improvement of signal-to-noise ratio of an estimated 7dB is expected to be achieved for the increased amplitude of signal prior to overload.

It is to be noted that the decimating filter placed after the sigma-delta converter to remove out of band noise must now accept a multi-bit input.

Of course, variations may be made. Thus, other pairings of secondary pulses can be made e.g. a positive secondary pulse at 60° and a negative secondary pulse at 120° simulate a positive primary pulse at 0°. This is also true for a positive secondary pulse at 300° and a negative secondary pulse at 240°, and for negative secondary pulses at 120° and 240°.

In a second form of sigma-delta converter, seven levels of quantisation are produced in analogue-to-digital converter 9, leading to an expected signal to noise ratio improvement of 17dB. This is achieved by tuning the tuned circuit 6, 7 to operate in the second null in the quantisation noise characteristic (Figure 2) i.e. a sampling of the analogue-to-digital converter 9 is now ⁴/₃ the intermediate frequency while maintaining the digital-to-analogue converter 4 output at every 30° of the i.f. waveform i.e. the digital-to-analogue converter remains at twelve times the i.f. frequency. Thus, one sampling period now lasts ¾ (Figure 3e) of the i.f. period instead of ¼, and hence there are three primary pulse positions and three pairs of secondary pulse positions per sampling period. The former can be +1 or -1, and the latter can also be +1 or -1, either subtracted from or added to the primary pulses.

Thus, for each output data sample, the maximum output pulse which can be simulated is +6 i.e. three primary pulses and three secondary pairs. If there is one negative pulse value and the other five are positive, the output is +4. If there are two negative pulses and the other four are positive, the output is +2. The same reasoning may be applied to produce -2, -4, -6 feedback pulse value per data sample. If there are three negative and three positive pulses, the output is zero. Hence linear feedback pulses of seven levels may be produced corresponding to seven levels of quantisation of the analogue-to-digital converter 9. Appropriate values for the look-up table to control the digital-to-analogue converter are chosen.

This embodiment provides increased signal-to-noise ratio at the expense of having to provide resonant circuits at higher resonant frequency.

In the third form of sigma-delta converter, the resonant circuits are tuned to operate in the ¾ the sampling frequency null, but only primary slots are used i.e. the digital-to-analogue converter operates at four times the i.f. frequency. Thus, for each output data sample, three primary data slots are available for feedback pulses. If positive pulses are applied in all three slots, a feedback pulse equivalent to a positive pulse of three units can be produced: if two pulses are positive and one is negative, a feedback pulse equivalent to one unit can be produced. Equally, feedback pulses equivalent to -1 and -3 units can be produced. The look-up table for the interpolation filter 10 is shown in Figure 5. The four quantisation levels of the converter 9, corresponding to 11, 10 etc, may be considered as 3, 1 etc. The group of feedback pulses corresponding to each I or Q data pulse of each level is as shown in Figure 5.

Hence, for this embodiment, the analogue-to-digital converter 2 encodes to four levels, and four levels of feedback are applied in step with those levels under the control of interpolating filter 10. With such an interpolator an improvement in signal-to-noise ratio of around 11dB is to be expected.

Of course variations are possible without departing from the scope of the invention. Thus, for example the three converters described could be first order i.e. employ only one resonant circuit instead of two, or could be third or higher order. An additional correction digital-to-analogue converter feeding the input of the analogue-to-digital converter 9 as claimed in our co-pending patent application GB-A-2232023 may be employed to restore performance or stability.

The circuit illustrated is unbalanced, but a balanced network may be used if desired i.e. both inverting and non-inverting outputs of the amplifiers 8 and 9 may be used.

Although described in relation to i.f. signals, which are typically of 10.7 MHz, it may be used for any H.F. or V.H.F. signals. Equally, the digital-to-analogue converter could be used for baseband or audio signals. If the circuit is used for baseband signals, then the filters take the form of integrators, and only primary feedback pulses are used.

Although in the embodiments the conversion from the multi-level output has been to a single bit feedback pulse generator, it would be permissible to convert from a multi-level output of analogue-to-digital converter 9 to a digital-to-analogue with a fewer number of levels (but more than two).

## Claims

1. An analogue-to-digital converter comprising an input for analogue signals, quantising means for producing a digital output with more than two levels of quantisation, a feedback loop for feeding a signal derived from the digital output to be combined in analogue form with the analogue input to form a difference signal for input to filter means, the filtered difference signal being applied to the input of the quantising means in use, wherein the feedback loop includes means for converting the signal derived from the digital output to a second digital signal with fewer levels of quantisation but a higher clocking rate than the digital output.

2. An analogue-to-digital converter as claimed in claim 1, in which the converting means includes a look-up table.

3. An analogue-to-digital converter as claimed in claim 1 or claim 2, in which the converting means is arranged to convert the signal derived from the digital output to a two level digital signal.

4. An analogue-to-digital converter as claimed in any one of claims 1 to 3 in which the clocking rate of the second digital signal is three times the clocking rate of the digital output.

5. An analogue-to-digital converter as claimed in claim 4, in which the signal combined in analogue form comprises groups of three pulses, two of which combine to reinforce or cancel the third.

6. An analogue-to-digital converter as claimed in any one of claims 1 to 3 , in which the signal combined in analogue form comprises groups of three pulses, any two of which combine to reinforce or cancel each other.

7. An analogue-to-digital converter as claimed in any one of claims 1 to 3, in which the clocking rate of the second digital signal is twelve times the clocking rate of the digital output.

8. An analogue-to-digital converter as claimed in any one of claims 1 to 7, in which the filter means is arranged to pass a band of frequencies centred on a frequency which is an odd multiple of one quarter of the sampling rate of the digital output.
